# EUROPEAN PATENT APPLICATION

(11) **EP 2 015 367 A1**
(43) Date of publication of application: **14.01.2009**
(21) Application number: 07742209.5
(22) Date of filing: 24.04.2007
(51) Int. Cl.: H01L 31/04

(54) **ELECTROCONDUCTIVE PASTE FOR SOLAR BATTERY ELECTRODE**

(30) Priority: 25.04.2006 JP 2006120834; 25.04.2006 JP 2006120835
(71) Applicant: SHARP CORPORATION, Osaka-shi, Osaka 545-8522 (JP); Namics Corporation, Niigata-shi, Niigata 950-3131 (JP)
(72) Inventor: MACHIDA, Tomohiro, c/o SHARP CORPORATION, Osaka 545-8522 (JP); TONOMURA, Yoshifumi, c/o SHARP CORPORATION, Osaka 545-8522 (JP); MIYAZAWA, Akira, c/o SHARP CORPORATION, Osaka 545-8522 (JP); OHHIRA, Keisuke, c/o SHARP CORPORATION, Osaka 545-8522 (JP); IIDA, Hideyo, c/o NAMICS CORPORATION, Niigata 950-3131 (JP); YAMAZAKI, Toshiei, c/o NAMICS CORPORATION, Niigata 950-3131 (JP)
(74) Representative: Betten & Resch
(86) International application number: PCT/JP2007/058774
(87) International publication number: WO 2007/125879

(57) **Abstract**

A conductive paste for solar cell electrodes with which high FF value can be obtained stably, and a method for producing a solar cell using the same are provided.

The conductive paste is a conductive paste for solar cell electrodes which includes an organic binder, a solvent, conductive particles, glass frits, and (A) a substance which changes into a gas at a temperature in the range of 150 to 800°C, and a metal oxide, (B) an organometallic compound and a metal oxide, or (C) a compound containing Al, Ga, In or Tl.

## Description

### Technical Field

The present invention relates to a conductive paste for solar cell electrodes, particularly a conductive paste for the electrodes of crystalline silicon solar cells such as single-crystalline or polycrystalline silicon solar cells; an electrode for solar cells formed by firing the conductive paste; a solar cell equipped with the electrode; and a method for producing a solar cell using the conductive paste.

### Background Art

A conventional solar cell which uses single-crystalline or polycrystalline silicon as the main material for semiconductor substrate, separates electron-hole pairs which are generated by the incident light absorbed in the semiconductor, by means of an electric field occurring at the PN junction provided near the substrate surface, and takes out the electrons to the outside in the form of electric current, through electrodes that are respectively formed to have low contact resistance with the P-type semiconductor and the N-type semiconductor.

For example, in the case of general polycrystalline silicon solar cells, PN junctions are formed by diffusing an element which is capable of forming an N-type diffusion layer, such as P (phosphorus atom), from one side surface of a P-type silicon substrate having B (boron atom) and the like added as impurities. In this case, in order to have a light-trapping effects, the surface of the P-type silicon substrate is subjected to texture (unevenness) processing, and then the N-type diffusion layer is formed.

The N-type diffusion layer side is defined as the light incident side, and a light incident side electrode consisting of bus electrodes and finger electrodes is formed on an anti-reflection layer made of silicon nitride, titanium oxide, or the like (film thickness 50 nm to 100 nm). On the back side, which is the P-type silicon substrate side, since light incidence does not have to occur there, the backside electrode is formed over nearly the entire surface. The two electrodes are required to be in ohmic contact with the respective semiconductors at low resistance.

The two electrodes are generally formed by printing, drying, and firing of a conductive paste. The composition of the conductive paste and firing conditions are particularly important for the properties of a solar cell.

The conductive paste in general includes an organic binder, a solvent, conductive particles, and glass frits, and optionally has additives incorporated. These components take the roles of controlling printability or the shape after printing, imparting the electroconductivity required from electrodes, maintaining adhesiveness to semiconductor substrates, firing through of the anti-reflection film, reducing the contact resistance with the semiconductor substrate and diffusion layer of the solar cell, and the like.

A conductive paste is printed directly on a semiconductor substrate or on an anti-reflection film formed on a diffusion layer by a screen printing method or the like, dried for several minutes at a temperature of about 100 to 150°C, and then rapidly fired for several minutes at about 600 to 850°C, to thus form a light incident side electrode or a backside electrode. With regard to the firing conditions, since the optimum conditions to obtain good solar cell properties vary with the conductive paste composition, conditions that are suitable for the paste composition are selected.

The effects exerted by an electrode on the conversion efficiency of a crystalline silicon solar cell and the stability of cell properties are large, and in particular, the effects of the light incident side electrode are enormous. As a measure of the electrode performance, the fill factor (FF) of a solar cell may be mentioned. When the series resistance of a solar cell increases, the FF value tends to decrease, and one of the constituent elements of series resistance is the contact resistance between the P-type semiconductor and N-type semiconductor, and the electrodes. In addition, the series resistance in a solar cell can be evaluated using, as an index, the slope of the tangent line at the Voc point (open-circuit voltage point) in the I-V (current-voltage) characteristics under irradiation of a solar cell.

For this reason, there have been heretofore suggested the following methods for incorporating various additives to a conductive paste for solar cell electrodes, for the purpose of obtaining high conversion efficiency and stable properties of solar cells.
(i) A conductive paste into which glass frits containing Bi₂O₃, B₂O₃ and SiO₂ are incorporated (Patent Document 1).
(ii) A conductive paste into which metals such as Ti, Zn and Y, or compounds thereof are added as fine particles having a size of 0.001 to 0.1 µm (Patent Document 2).
(iii) A conductive paste containing Ti, Bi, Co, Zr, Fe or Cr (Patent Document 3).
(iv) A conductive paste into which halides are added (Patent Document 4).

However, for all of the conductive pastes, there have been problems such as that a sufficiently high FF (fill factor) value cannot be obtained in solar cells having electrodes which are formed using the conductive pastes, and that the FF value undergo large changes as a result of fluctuation in the firing temperature for forming electrodes.

Patent Document 1: Japanese Laid-open Patent [Kokai] Publication No. Hei 11-329072
Patent Document 2: Japanese Laid-open Patent [Kokai] Publication No. 2005-243500
Patent Document 3: Japanese Laid-open Patent [Kokai] Publication No. 2001-313400
Patent Document 4: Japanese Laid-open Patent [Kokai] Publication No. 2001-118425

### Disclosure of the Invention

### Problems to be Solved by the Invention

Objects of the present invention are to provide a conductive paste for solar cell electrodes, with which high FF value can be obtained stably for electrodes that are to be brought into ohmic contact with the P-type semiconductor and N-type semiconductor of a crystalline silicon solar cell; an electrode for solar cells formed by firing the conductive paste; a solar cell equipped with the electrode; and a method for producing a solar cell using the conductive paste.

### Means for Solving the Problems

The inventors of the present invention paid attention, in particular, to the uniformization of the composition of electrode near the interface with semiconductor and the reactivity of additives, and devotedly conducted investigation. As a result, they found that incorporating (A) a substance which changes into a gas at a temperature in the range of 150 to 800°C into a conductive paste for solar cell electrodes, is very effective in obtaining high FF value stably, and thus they completed the present invention.

In other words, the present invention is a conductive paste for solar cell electrodes, which includes an organic binder, a solvent, conductive particles, glass frits, a metal oxide, and (A) a substance which changes into a gas at a temperature in the range of 150 to 800°C. As will be described later, conductive pastes are generally subjected to a temperature in the range of 150 to 800°C in the firing process.

It is more preferable for the conductive paste for solar cell electrodes of the present invention, that the metal oxide be one or more selected from the group consisting of zinc oxide, titanium oxide and tin oxide. It is also preferable that the (A) substance which changes into a gas at a temperature in the range of 150 to 800°C be an organometallic compound, and it is more preferable that the organometallic compound is one or more selected from the group consisting of acetylacetone metal complexes, acetoacetic acid metal complexes, diethylmalonic acid ester metal complexes, cyclopentadiene complexes, metal naphthenate compounds, metal octoate compounds, metal stearate compounds, and metal palmitate compounds.

The present invention is also a conductive paste for solar cell electrodes, which includes an organic binder, a solvent, conductive particles and glass frits, and further includes (B) an organometallic compound and a metal oxide. These organometallic compound and metal oxide are preferably the compounds described in the above.

Furthermore, in general, when a Group III element is present in the electrode, an acceptor level is formed in the semiconductor. Thus, when such electrode is bonded with N-type semiconductor, the acceptor level compensates the donor level which has been formed in the N-type semiconductor, and an increase in the contact resistance is expected. The inventors of the present invention found that when Al, Ga, In or Tl, which are all Group III elements, is incorporated into a conductive paste for solar cell electrodes in the form of a compound, an electrode formed on the N-type semiconductor using such a paste has low contact resistance with the N-type semiconductor, contrary to the expectation, and results in an excellent FF value for the solar cell, thus completing the present invention.

In other words, the present invention is a conductive paste for solar cell electrodes, characterized in comprising an organic binder, a solvent, conductive particles, glass frits, and (C) a compound containing Al, Ga, In or T1.

The present invention also relates to an electrode for solar cells formed by firing the above-described conductive paste. Furthermore, the present invention relates to a solar cell equipped with the electrode. In addition, the present invention also relates to a method for producing a solar cell using the conductive paste.

### Effects of the Invention

When the conductive paste for solar cell electrodes of the present invention is used, a solar cell having a high FF value can be obtained, and the performance of solar cells can be enhanced.

### Brief Description of the Drawings

Fig. 1 shows the thermal analysis results for indium acetylacetone compound.
Fig. 2 shows the basic structure of a solar cell.
Fig. 3 is a diagram showing the peak temperature of firing and FF value for the solar cell of Example 1.

### Reference Numerals

- 1: Light incident side electrode
- 2: Anti-reflection film
- 3: N-type diffusion layer
- 4: P-type silicon substrate
- 5: Backside electrode

### Best Mode for Carrying Out the Invention

According to a first embodiment of the present invention, the conductive paste for solar cell electrodes includes an organic binder, a solvent, conductive particles, glass frits, a metal oxide, and (A) a substance which changes into a gas at a temperature in the range of 150 to 800°C.

### (1) Organic binder and solvent

The organic binder and the solvent take the role of adjusting the viscosity of the conductive paste, or the like, and neither is particularly limited. The organic binder may also be used while being dissolved in the solvent.

As for the organic binder, cellulose-based resins, for example, ethyl cellulose, nitrocellulose and the like; (meth)acrylic resins, for example, polymethyl acrylate, polymethyl methacrylate and the like may be mentioned. As the organic solvent, alcohols, for example, terpineol, α-terpineol, β-terpineol and the like; esters, for example, hydroxyl group-containing esters, 2,2,4-trimethyl-1,3-pentanediol monoisobutyrate, butylcarbitol acetate and the like can be used.

### (2) Conductive particles

The conductive particles are not particularly limited, and for example, Ag, Cu, Ni and the like may be mentioned. Ag is preferred because it can be fired in air. The shape and average particle dimension of the conductive particles are not particularly limited, and those known in the art can be used. As for the shape of the conductive particles, a spherical shape, a scale shape and the like may be mentioned. The average particle dimension of the conductive particles of 0.05 to 10 µm may be mentioned, and it is preferably 0.1 to 5 µm, from the viewpoint of workability. If addition, the average particle dimension refers to the respective average values of the particle diameter in the case of a spherical shape, of the major diameter of a particle flake in the case of a scale shape, and of the length in the case of a needle shape.

### (3) Glass frits

The glass frits are not particularly limited, and Pb-based glass frits, for example, PbO-B₂O₃ -SiO₂-based glass frits, and the like; Pb-free glass frits, for example, Bi₂O₃-B₂O₃-SiO₂-CeO₂LiO₂-NaO₂-based glass frits, and the like may be mentioned. The shape and size of the glass frits are not particularly limited, and those known in the art can be used. As for the shape of the glass frits, a spherical shape, an amorphous shape and the like may be mentioned. The average particle dimension of the glass first may be 0.01 to 10 µm, and preferably 0.05 to 1 µm, from the viewpoint of workability or the like. The average particle dimension is as previously described above, but in the case of an amorphous shape, the dimension refers to the average of the longest diameter.

### (4) Metal oxide

For the conductive paste of the present invention, it is effective in obtaining high FF value if a metal oxide such as zinc oxide, titanium oxide, tin oxide, copper oxide or nickel oxide, and particularly, zinc oxide, titanium oxide or tin oxide, is used in combination. Specifically, ZnO, TiO₂ and SnO₂ may be mentioned. Additionally, a substance which is a metal oxide but is also capable of changing into a gas at a temperature in the range of 150 to 800°C, is considered not as a metal oxide, but as the (A) substance which changes into a gas at a temperature in the range of 150 to 800°C.

The metal oxide is usually solid at normal temperature, and the shape and average particle dimension are not particularly limited. As for the shape, a spherical shape, an amorphous shape and the like may be mentioned. As for the average particle dimension, a size of 0.05 to 1 µm is preferred from the viewpoint of dispersibility or the like.

The metal oxide is believed to contribute to providing the sites for the conductive particles to contact with the semiconductor surface by preventing excessive sintering of the conductive particles during the firing process, while preventing the enlargement of liquefied glass which originates from the glass frits. In this case, if a gas generated by the gasification or sublimation of a substance which changes into a gas at a temperature in the range of 150 to 800°C as will be described in the following (for example, an organometallic compound) is co-present, it is thought that the conductive particles can achieve better contact with the semiconductor.

### (5) Substance which changes into a gas

The conductive paste of the present invention is characterized by including (A) a substance which changes into a gas at a temperature in the range of 150 to 800°C. Such substance may be a simple element (composed of one kind of an element) or a compound (composed of two or more kinds of elements).

In general, the peak of the firing temperature for the conductive paste is set to about 850°C in order to suppress adverse effects on the PN junction; therefore, the conductive paste is subjected to the temperature in the range of 150 to 800°C in the firing process.
According to the present invention, when the conductive paste incorporated with a substance which changes into a gas at this temperature range is used in the production of electrodes for solar cells, a solar cell having a high FF value can be obtained.

With regard to the substance which can change into a gas at a temperature in the range of 150 to 800°C, it is acceptable if the temperature at which the change into a gas is initiated by thermogravimetric analysis (temperature at which weight reduction is initiated) or the temperature at which the change into a gas is completely finished (temperature at which the weight becomes almost constant) is in the range of 150 to 800°C, and preferably, both the temperature at which the change into a gas is initiated and the temperature at which the change into a gas is completely finished are in the range of 150 to 800°C.

The upper limit 800°C is a result of taking into consideration that the peak of the firing temperature for the conductive paste for solar cell electrodes is usually up to about 850°C, whereas the lower limit 150°C is a result of taking into consideration of the suppression of film swelling or generation, of pinholes, and of the drying process. The temperature range for changing into a gas of 150 to 800°C is more preferably from 200 to 600°C.

It is thought that since the conductive paste for solar cell electrodes of the present invention is incorporated with the (A) substance which changes into a gas at a temperature in the range of 150 to 800°C, which may be said to be a temperature of exposure in the firing process, the effects obtained by incorporating the substance, such as that the gas generated in the firing process diffuses to a large extent to thereby bring about a uniform electrode composition near the interface with the semiconductor, are exhibited to a large extent, and as a result, a solar cell having a high FF value is obtained.

The (A) substance which changes into a gas at a temperature in the range of 150 to 800°C, can be incorporated into the conductive paste in the form of solid, liquid, or a solution in a solvent capable of dissolving a solid. In the case of incorporating the substance in the form of solid, since the substance finally changes into a gas, the shape and average particle dimension have only little influence and are not particularly limited. As for the shape, a spherical shape, an amorphous shape and the like may be mentioned. As for the average particle dimension, 0.01 to 10 µm may be mentioned from the viewpoint of dispersibility, and the size is, for example, 0.1 to 1 µm.

For these substances which change into a gas, during the firing process for the conductive paste, a solid melts into a liquid and then turns into a gas (gasification), or directly turns into a gas without going through becoming a liquid (sublimation), along with the elevation of temperature. In the case where the substance is dissolved in a solvent and used, after the solvent evaporates, the substance changes into a liquid or into a solid, and then changes into a gas. There are cases where the generated gas maintains the original molecular structure of the substance, while there are also cases where the substance undergoes thermal degradation and changes into a gas having a reduced molecular weight.

According to the present invention, as the (A) substance which changes into a gas at a temperature in the range of 150 to 800°C, various inorganic substances and organic substances can be used, and in the case of organic substances, organometallic compounds in particular can be preferably used. The organometallic compounds in the present specification are defined as organic compounds containing various metals.

Inorganic substances which gasify or sublime at a temperature in the range of 150 to 800°C, may be exemplified by inorganic compounds such as diphosphorus pentoxide, inorganic simple elements such as red phosphorus and iodine, or the like.

In the case of organic substances, a broader range of materials than inorganic substances can be selected, and in particular, organometallic compounds are suitable as the substance which can change into a gas at a temperature in the range of 150 to 800°C.

For example, organometallic compounds having an acetylacetone group represented by [M(CH₃COCHCOCH₃)ₙ] (M being a metal) usually begin to change into gases at a temperature near 150°C and completely change into gases at about 300°C, and thus the compounds are suitable for use.

In general, the gasification or sublimation temperature for the organometallic compounds is predominantly determined not by the kind of metal, but by the organic group which binds with metal, such as an acetylacetone group, and therefore, the temperature range becomes relatively low and narrow. Since organometallic compounds have a gasification or sublimation temperature lower than that of compounds having the same metals, such as oxides, hydroxides, and halides, and usually begin to change into gases at 100 to 400°C, the organometallic compounds are adequate to be selected as the substance to be incorporated into the conductive paste for solar cell electrodes.

As for the organometallic compound which changes into a gas at a temperature in the range of 150 to 800°C, organometallic compounds of typical metal elements or transition metal elements such as Al, Ga, In, Tl, Zn, Ni, Pd, Pt, Co, Ir, Sn, Pb, Ti, Zr, Hf, Cu, Fe, Ru, Mn, V, Nb, Mo, W, Mn, Mg, Ca, K, Li, Ce, Y and Sb, are commercially available and can be used. For example, diketone complexes or carboxylic acid salts of these metals can be used. Examples of the diketone complexes include acetylacetone metal complexes, metal acetoacetate complexes, diethylmalonic acid ester metal complexes, cyclopentadiene complexes, and the like. Examples of the carboxylic acid salts include metal naphthenate compounds, metal octoate compounds, metal stearate compounds, metal palmitate compounds, and the like.

Organometallic compounds containing In, Sn, Y, Ni, Cu, Mag, Pb, Zn or Ga as the metal element are more preferred, and organometallic compounds containing In, Sn, Ga, Ni or Cu are particularly preferred. Among them, acetylacetone metal complexes, metal octoate compounds and metal naphthenate compounds containing any of these metal elements are preferred, and specifically, acetylacetone indium compound, acetylacetone yttrium compound, acetylacetone gallium compound, tin octoate, nickel octoate, magnesium octoate, copper naphthenate, lead naphthenate, zinc naphthenate, and the like may be mentioned.

These organometallic compounds are liquid or solid at normal temperature, and may be incorporated into the conductive paste as they are, but these may also be dissolved or dispersed in a solvent such as toluene, ethanol, acetylacetone or methylene chloride, and used.

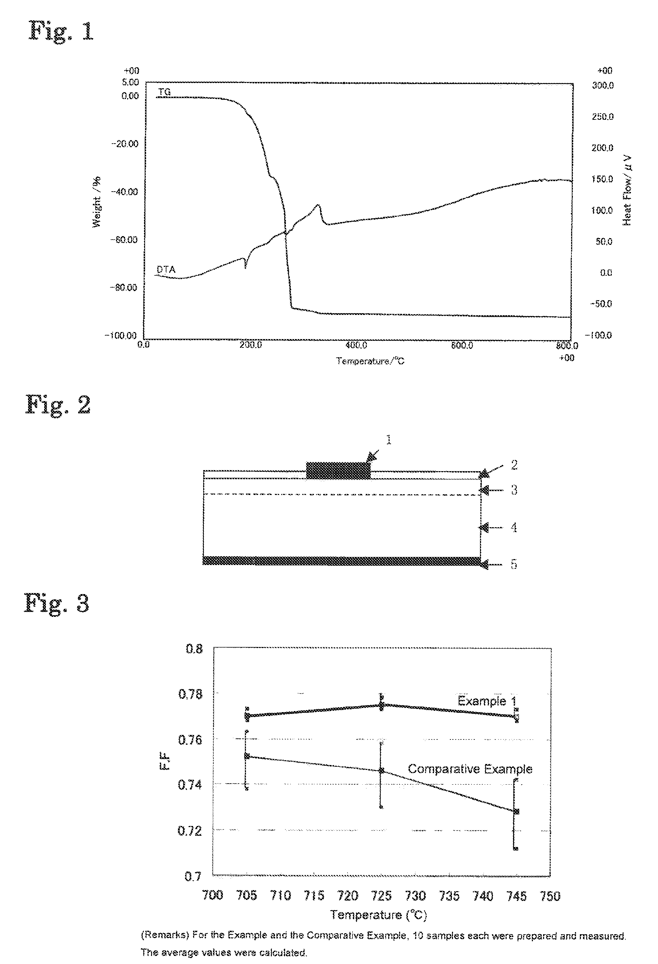

Fig. 1 shows the results of thermogravimetric analysis of acetylacetone indium compound as an example of the organometallic compound. Decomposition and gasification start at a temperature near 150°C, and gasification is completed art a temperature near 300°C, while about 5% of indium remains in the form of oxide. As such, a substance which starts changing into a gas at a temperature above the drying temperature, and finishes changing into a gas before reaching the peak of firing, is preferred as the (A) substance which changes into a gas at a temperature in the range of 150 to 800°C.

The conductive paste of the present invention may have optional components such as dispersant and plasticizer incorporated thereinto, within the scope of not impairing the effects of the present invention.

With regard to the conductive paste of the present invention, the content of the glass frits is preferably 0.5 to 10 parts by weight, and more preferably 1 to 5 parts by weight, relative to 100 parts by weight of the conductive particles, from the viewpoint of securing sufficient adhesive strength and suppressing an increase in the contact resistance. Within this range, good adhesive strength and a low contact resistance value can be obtained.

The content of the metal oxide is preferably 0.5 to 15 parts by weight, and more preferably 2 to 10 parts by weight, relative to 100 parts by weight of the conductive particles. Within this range, sufficient effects of incorporation of the component are easily obtained.

The content of the (A) substance which changes into a gas at a temperature in the range of 150 to 800°C is preferably 0.1 to 10 parts by weight, and more preferably 0.5 to 5 parts by weight, relative to 100 parts by weight of the conductive particles. Within this range, sufficient effects of incorporation of the component are easily obtained.

In addition, for the organic binder and the solvent, appropriate amounts can be selected so as to obtain a viscosity which is appropriate according to the coating and printing methods for the conductive paste.

The method for producing the conductive paste of the present invention is not particularly limited. The conductive paste can be prepared by kneading an organic binder, a solvent, conductive particles, glass frits, a metal oxide, (A) a substance which changes into a gas at a temperature in the range of 150 to 800°C, and other optional components using a planetary mixer or the like, and then subjecting the mixture to dispersion using a triple roll mill or the like.

The conductive paste of the present invention can be used in the production of electrodes for solar cells, and particularly, good contact with the N-type semiconductor can be obtained.

The method for producing an electrode for solar cells and the method for producing a solar cell are not particularly limited. An example will be described using Fig. 2.

Optionally, a texture is formed on the surface of a P-type polycrystalline silicon substrate 4, and then P (phosphorus) and the like is thermally diffused at 900°C to form an N-type diffusion layer 3. Subsequently, an anti-reflection film 2 such as a silicon nitride thin film or a titanium oxide film is formed to a thickness of 50 to 100 nm by a plasma CVD method or the like. The conductive paste of the present invention is screen printed on the anti-reflection film 2 as a light incident side electrode, and is dried by evaporating the solvent at about 150°C. Subsequently, a paste for aluminum electrode is optionally printed on the back side of the P-type polycrystalline silicon substrate 4 by screen printing, as a backside electrode, and is dried. Then, the assembly is fired to obtain a solar cell equipped with a light incident side electrode 1 and a backside electrode 5.

At this time, the firing conditions are preferably set such that the peak temperature of firing is higher than the temperature at which gasification or sublimation of the (A) substance which changes into a gas at a temperature in the range of 150 to 800°C, which is incorporated into the conductive paste of the present invention, is initiated, and it is more preferable that the conditions is set such that the peak temperature is higher than the above-mentioned temperature by 200°C or more.

The conductive paste for solar cell electrodes of a second embodiment of the present invention is a conductive paste for solar cell electrodes which includes an organic binder, a solvent, conductive particles and glass frits, and further includes (B) an organometallic compound and a metal oxide. The type, size and amount of incorporation of the organic binder, solvent, conductive particles, glass frits and the other optional components are the same as in the case of the conductive paste of the first embodiment. When the (B) organometallic compound and metal oxide are used in combination, a solar cell having a high FF value is obtained.

The effects of using the (B) organometallic compound and metal oxide in combination in the conductive paste are thought to be of the same mechanism as that of the first embodiment. Specific examples of the organometallic compound and the metal compound are the same as those for the first embodiment. The amounts of incorporation of the organometallic compound and the metal compound are such that the amount for the organometallic compound is preferably 0.1 to 10 parts by weight, and more preferably 0.5 to 5 parts by weight, while the amount for the metal oxide is preferably 0.5 to 15 parts by weight, and more preferably 2 to 10 parts by weight, both relative to 100 parts by weight of the conductive particles.

Furthermore, the methods for producing a conductive paste for solar cell electrodes, a solar cell electrode and a solar cell are also the same as those for the first embodiment.

The conductive paste for solar cell electrodes of a third embodiment of the present invention includes an organic binder, a solvent, conductive particles, glass frits, and (C) a compound containing Al, Ga, In or Tl. The type, size, amount of incorporation and the like of the organic binder, solvent, conductive particles, glass frits and the other optional components are the same as in the case of the conductive paste of the first embodiment.

The conductive paste of the third embodiment of the present invention includes (C) a compound containing Al, Ga, In or Tl. These compounds may be used individually alone or in combination of two or more species.

As the compound, there may be mentioned oxides, hydroxides and organometallic compounds. In the present specification, the organometallic compounds refer to organic compounds containing various metals, and diketone complexes or carboxylic acid salts can be used. Examples of the diketone complexes include acetylacetone metal complexes, metal acetoacetate complexes, diethylmalonic acid ester metal complexes, cyclopentadiene complexes, and the like. Examples of the carboxylic acid salts include metal (meth)acrylate compounds, metal naphthenate compounds, metal octoate compounds, metal stearate compounds, metal palmitate compounds and the like. Preferred are acetylacetone metal complexes or metal octoate compounds.

The Al compound may be exemplified by Al₂O₃, Al(OH)₃, Al(C₅H₇O₂)₃, aluminum acrylate, or the like; the Ga compound may be exemplified by Ga₂O₃, Ga(OH)₃, Ga(C₅H₇O₂)₃, or the like; the In compound may be exemplified by In₂O₃, In(OR)₃, In(C₅H₇O₂)₃, or the like; and the Tl compound may be exemplified by Tl₂O₃, Tl(OH)₃, Tl(C₅H₇O₂)₃ or the like.

The (C) compound containing Al, Ga, In or Tl is usually solid or liquid, and can be incorporated into the conductive paste as it is. In the case of solid, the shape or size has little influence, but from the viewpoint of workability or the like, a compound having an average particle dimension of 0.05 to 10 µm is preferred, and for example, a compound having an average particle dimension of 0.15 to 5 µm can be used. Furthermore, the compound can also be dissolved or dispersed in a solvent such as toluene, ethanol, acetylacetone or methylene chloride, and used.

The mechanism of the (C) compound containing Al, Ga, In or Tl at the time of forming an electrode from the conductive paste is not clear, but is conceived as follows. During the formation of an electrode, the conductive paste is applied and dried on a substrate, and then is generally subjected to short time firing, such as an in-out time of several minutes, at a firing temperature of 600 to 800°C. It is difficult to think that such temperature and time causes the occurrence of the substitution of silicon of the N-type semiconductor substrate with a Group III element. On the other hand, since the metals obtained by reducing these compounds have relatively low melting points, it is thought that a metal reduced in the firing process is dispersed in the molten state, and exists at the conductor/electrode interface, to contribute to the formation of good contact.

For the conductive paste of the third embodiment of the present invention, it is effective in obtaining high FF value if zinc oxide, titanium oxide, tin oxide, copper oxide or nickel oxide is used in combination. These specific metal oxides may be used individually alone or in combination of two or more species.

These specific metal oxides are believed to contribute to providing the sites for the conductive particles to contact with the semiconductor surface by preventing excessive sintering of the conductive particles during the process of firing the conductive paste, and at the same time, preventing the enlargement of liquefied glass which originates from the glass frits. Also, the fact that the metal oxides can be reduced in a reducing atmosphere provided by CO derived from the organic binder or the like and become semiconductive, also helps in obtaining good contact. Among these specific metal oxides, zinc oxide, titanium oxide and tin oxide are preferred, and specifically, ZnO, TiO₂ and SnO₂ are mentioned.

The specific metal oxide is usually solid at normal temperature, and the shape and average particle dimension are not particularly limited. As for the shape, a spherical shape, an amorphous shape and the like may be mentioned. The average particle dimension is preferably 0.05 to 1 µm from the viewpoint of dispersibility or the like.

Furthermore, the content of the (C) compound containing Al, Ga, In or Tl is preferably 0.001 to 10 parts by weight, and more preferably 0.02 to 5 parts by weight, relative to 100 parts by weight of the conductive particles. Within this range, sufficient effects of incorporation of the component are easily obtained.

Furthermore, in the case of incorporating a specific metal oxide, the content of the specific metal oxide is preferably 0.5 to 15 parts by weight, more preferably 2 to 10 parts by weight, relative to 100 parts by weight of the conductive particles. Within this range, sufficient effects of incorporation of the component are easily obtained. Moreover, in the case of using a specific metal oxide, the compounds of Al, Ga, In or Tl can exhibit sufficient effects even at a value close to the lower limit of the above-mentioned range of the amount of incorporation (for example, less than 0.1 parts by weight, for example, 0.001 to 0.08 parts by weight, relative to 100 parts by weight of the conductive particles).

The method for producing the conductive paste of the third embodiment of the present invention is not particularly limited, and the conductive paste can be prepared by first kneading an organic binder, a solvent, conductive particles, glass frits, (C) a compound containing Al, Ga, In or Tl, optionally a metal oxide, and other optional components using a planetary mixer or the like, and then subjecting the mixture to dispersion using a triple roll mill (made of metal or ceramic) or the like.

The conductive paste of the third embodiment of the present invention can be used in the production of electrodes for solar cells. In particular, since good contact with the N-type semiconductor can be obtained, the conductive paste is useful for forming an electrode on the N-type semiconductor (for example, N-type diffusion layer)_{.}

The method for producing an electrode for solar cells and the method for producing a solar cell of the current embodiment are the same as in the case of the first embodiment.

### EXAMPLES

In the Examples, a solar cell was produced as follows. A texture was formed on the surface of a P-typo polycrystalline silicon substrate doped with B (boron) (substrate thickness 200 µm) by wet etching. Thereafter, P (phosphorus) was thermally diffused to form an N-type diffusion layer (thickness 0.3 µm), Subsequently, an anti-reflection film constituted of a silicon nitride thin film (thickness about 60 nm) was formed from silane gas and ammonia gas by a plasma CVD method. The resulting substrate with anti-reflection film was cut to a size of 15 mm x 15 mm and used.

The paste described in the each of the following Examples was printed on the anti-reflection film by screen printing, such that the thickness would be approximately 20 µm, in a pattern composed of a bus electrode and a finger electrode, and the assembly was dried at 150°C for about 1 minute.

Subsequently, a paste for aluminum electrodes was printed on the back side of the P-type polycrystalline silicon substrate 1 by screen printing, such that the thickness would be approximately 20 µm, and the assembly was dried at 150°C for about 1 minute.

Thereafter, the substrate having pastes printed and dried on both sides was fired under the conditions described in each of the Examples, to obtain a solar cell equipped with a light incident side electrode and a backside electrode.

The current-voltage characteristics of the solar cells were measured under the light of Solar Simulator (AM 1.5, energy density 100 mW/cm²), and FF value was calculated from the measurement results.

### Example 1

This is an example of using indium acetylacetone compound, which is an organometallic compound, as the (A) substance which changes into a gas at a temperature in the range of 150 to 800°C. It is shown from the comparison with the case of no addition of the compound, that high FF value can be maintained in a broad temperature region by adding a gasifying substance into the conductive paste, and that effects of obtaining FF values with less fluctuation can be obtained.

The composition (expressed in parts by weight) of the conductive paste is as shown in Table 1. The conductive paste was prepared by mixing the respective components with a planetary mixer and a triple roll mill.

**Table 1**

| | | Example 1 | Comparative Example |
|---|---|---|---|
| Organic binder | Ethyl cellulose | 3 | 3 |
| Solvent | 2,2,4-Trimethyl-1,3-pentanedlol monoisobutyrate | 13 | 13 |
| Conductive particles | Ag (spherical shape, average particle dimension 0.4 µm) | 100 | 100 |
| Glass frits | Pb-based glass frits (PbO-B₂O₃-SiO₂, amorphous shape, average particle dimension 0.1 µm) | 2 | 2 |
| Substance which changes into gas | In(C₅H₇O₂]₃ (amorphous shape, average particle dimension 0.2 µm) | 1 | 0 |
| Metal oxide | ZnO (spherical shape, average particle dimension 0.2 µm) | 9 | 9 |

| | | | |
|---|---|---|---|
| *In(C₅H₇O₂)₃ is acetylacetone indium compound. Amorphous shape, average particle dimension 0.2 µm (also the same in other Examples) | | | |

The firing conditions are a peak temperature of 705°C, 725°C or 745°C, and a firing time of 2 minutes.

The FF values for the resulting solar cells are presented in Fig. 3. In the case of using the conductive paste of Example 1, high FF values were shown at any temperature, and also, the fluctuation was small. On the other hand, in the case of using the conductive paste of Comparative Example, when the temperature increased, the FF value decreased, and fluctuation in the FF value was also large.

### Example 2

This is an example of using acetylacetone indium compound, which is an organometallic compound, as the substance which changes into a gas in a specific temperature range, and changing the amount of addition.

The composition (expressed in parts by weight) of the conductive paste is as presented in Table 2. The conductive paste was prepared by mixing the respective components with a planetary mixer, and dispersing the components with a triple roll mill.

**Table 2**

| | | Example 2-1 | Example 2-2 | Example 2-3 | Comparative Example |
|---|---|---|---|---|---|
| Organic binder | Ethyl cellulose | 3 | 3 | 3 | 3 |
| Solvent | 2,2,4-Trimethyl-1,3-pentanediol monoisobutyrate | 13 | 13 | 13 | 13 |
| Conductive particles | Ag (spherical shape, average particle dimension 0.4 µm) | 100 | 100 | 100 | 100 |
| Glass frits | Pb-based glass frits (PbO-B₂O₃-SiO₂, amorphous shape, average particle dimension 0.1 µm) | 2 | 2 | 2 | 2 |
| Substance which changes into gas | In(C₅H₇O₂)₃ (amorphous shape, average particle dimension 0.2 µm) | 0.5 | 1 | 1.5 | 0 |
| Metal oxide | ZnO (spherical shape, average particle dimension 0.2 µm) | 9 | 9 | 9 | 9 |
| FF | | 0.764 | 0.774 | 0.772 | 0.728 |

The firing conditions are a peak temperature of 725°C, and a firing time of 2 minutes.

The FF values for the resulting solar cells are presented in Table 2. Examples 2-1 to 2-3 where acetylacetone indium compound was added, showed high FF values at any amount of addition.

### Example 3

This is an example of using acetylacetone indium compound, which is an organometallic compound, as the substance which changes into a gas in a specific temperature range, and changing the amount of ZnO as the metal oxide.

The composition (expressed in parts by weight) of the conductive paste is as presented in Table 3. The conductive paste was prepared by mixing the respective components with a planetary mixer, and dispersing the components with a triple roll mill.

**Table 3**

| | | Example 3-1 | Example 3-2 | Example 3-3 | Example 3-4 | Example 3-5 | Example 3-6 | Comparative Example |
|---|---|---|---|---|---|---|---|---|
| Organic binder | Ethyl cellulose | 3 | 3 | 3 | 3 | 3 | 3 | 3 |
| Solvent | 2,2,4-Trimethyl-1,3-pentanediol monoisobutyrate | 13 | 13 | 13 | 13 | 13 | 13 | 13 |
| Conductive particles | Ag (spherical shape, average particle size 0.4 µm) | 100 | 100 | 100 | 100 | 100 | 100 | 100 |
| Glass frits | Pb-based glass frits (PbD-B₂O₃-SiO₂, amorphous shape, average particle size 0.1 µm) | 2 | 2 | 2 | 2 | 2 | 2 | 2 |
| Substance which changes into gas | In(C₅H₇O₂)₃ (amorphous shape, average particle size 0.2 µm) | 1 | 1 | 1 | 1 | 1 | 1 | 1 |
| Metal oxide | ZrO (spherical shape, average particle size 0.2 µm) | 0.5 | 1 | 4 | 9 | 15 | 20 | 0 |
| FF | | 0.696 | 0.720 | 0.771 | 0.774 | 0.711 | 0.513 | 0.480 |

The firing conditions are a peak temperature of 725°C, and a firing time of 2 minutes.

The FF values for the resulting solar cells are presented in Table 3. Examples 3-1 to 3-6 in which ZnO was added, showed higher FF values than the Comparative Example in which ZnO was not added. In particular, those Examples in which ZnO was added in an amount of 0.5 to 15 parts by weight, and particularly 1 to 15 parts by weight, showed high FF values.

### Example 4

This is an example of incorporating various organometallic compounds which change into gases by gasifying or subliming in a specific temperature range, into a conductive paste incorporated with Pb-based glass frits as the glass frits and ZnO as the metal oxide.

The composition (expressed in parts by weight) of the conductive paste is as presented in Table 4. The conductive paste was prepared by mixing the respective components with a planetary mixer, and dispersing the components with a triple roll mill.

**Table 4**

| | | Example 4-1 | Example 4-2 | Example 4-3 | Example 4-4 | Example 4-5 | Example 4-6 | Example 4-7 | Example 4-8 | Example 4-9 |
|---|---|---|---|---|---|---|---|---|---|---|
| Organic binder | Ethyl cellulose | 3 | 3 | 3 | 3 | 3 | 3 | 3 | 3 | 3 |
| Solvent | 2,2,4-Trimethyl-1,3-pentanediol monoisobutyrate | 13 | 13 | 13 | 13 | 13 | 13 | 13 | 13 | 13 |
| Conductive particles | Ag (spherical shape, average particle dimension 0.4 µm) | 100 | 100 | 100 | 100 | 100 | 100 | 100 | 100 | 100 |
| Glass frits | Pb-based glass frits (PbO-B₂O₃-SiO₂, amorphous shape, average particle dimension 0.1 µm) | 2 | 2 | 2 | 2 | 2 | 2 | 2 | 2 | 2 |
| Substance which changes into gas * | In(C₅H₇O₂)₃ | 1 | | | | | | | | |
| | Tin octoate | | 1 | | | | | | | |
| | Y(C₅H₇O₂)₃ | | | 1 | | | | | | |
| | Nickel octoate | | | | 1 | | | | | |
| | Copper naphthenate | | | | | 1 | | | | |
| | Magnesium octoate | | | | | | 1 | | | |
| | Lead naphthenate | | | | | | | 1 | | |
| | Zinc naphthenate | | | | | | | | 1 | |
| | Ga(C₅H₇O₂)₃ | | | | | | | | | 1 |
| Metal oxide | ZnO (spherical shape, average particle dimension 0.2 µm) | 9 | 9 | 9 | 9 | 9 | 9 | 9 | 9 | 9 |
| FF | | 0.777 | 0.774 | 0.766 | 0.770 | 0.764 | 0.764 | 0.763 | 0.766 | 0.774 |

| | | | | | | | | | | |
|---|---|---|---|---|---|---|---|---|---|---|
| * Tin octoate, nickel octoate, magnesium octoate: liquid at normal temperature. Rapidly gasifying at about 300°C, and gasification completed at about 350°C. * Copper naphthenate, lead naphthenate, zinc naphthenate: liquid at normal temperature. Gas at about 300°C. * Y(C₅H₇O₂)₃: acetylacetone yttrium compound. Solid at normal temperature. Gasification begins at about 150°C. Amorphous shape, average particle dimension 0.2 µm (also the same in other Examples). * Ga(C₅H₇O₂)₃: acetylacetone gallium compound. Solid. at normal temperature. Gasification begins at about 150°C. Amorphous shape, average particle dimension 0.2 µm (also the same in other Examples). | | | | | | | | | | |

The firing conditions are a peak temperature of 725°C, and a firing time of 2 minutes. The FF values for the resulting solar cells are presented in Table 4. All of the Examples showed high FF values.

### Example 5

This is an example of incorporating various organometallic compounds which change into gases by gasifying or subliming in a specific temperature range, into a conductive paste incorporated with Pb-free glass frits as the glass frits and ZnO as the metal oxide.

The composition (expressed in parts by weight) of the conductive paste is as presented in Table 5. The conductive paste was prepared by dispersing the respective components with a triple roll mill.

**Table 5**

| | | Example 5-1 | Example 5-2 | Example 5-3 | Example 5-4 | Example 5-5 | Example 5-6 | Example 5-7 | Example 5-8 |
|---|---|---|---|---|---|---|---|---|---|
| Organic binder | Ethyl cellulose | 3 | 3 | 3 | 3 | 3 | 3 | 3 | 3 |
| Solvent | 2,2,4-Trimethyl-1,3-pentanediol monoisobutyrate | 13 | 13 | 13 | 13 | 13 | 13 | 13 | 13 |
| Conductive particles | Ag (spherical shape, average particle dimension 0.4 µm) | 100 | 100 | 100 | 100 | 100 | 100 | 100 | 100 |
| Glass frits | Pb-free glass frits (Bi₂O₃-B₂O₃-SiO₂-CeO₂-LiO₂-NaO₂. amorphous shape, average particle dimension 0.1 µm) | 2 | 2 | 2 | 2 | 2 | 2 | 2 | 2 |
| Substance which changes into gas | In(C₅H₇O₂)₃ | 1 | | | | | | | |
| | Tin octoate | | 1 | | | | | | |
| | Y(C₅H₇O₂)₃ | | | 1 | | | | | |
| | Nickel octoate | | | | 1 | | | | |
| | Copper naphthenate | | | | | 1 | | | |
| | Magnesium octoate | | | | | | 1 | | |
| | Zinc naphthenate | | | | | | | 1 | |
| | Ga(C₅H₇O₂)₃ | | | | | | | | 1 |
| Metal oxide | ZnO (spherical shape, average particle dimension 0.2 µm) | 9 | 9 | 9 | 9 | 9 | 9 | 9 | 9 |
| FF | | 0.754 | 0.726 | 0.750 | 0.741 | 0.730 | 0.735 | 0.750 | 0.753 |

The firing conditions are a peak temperature of 725°C, and a firing time of 2 minutes.

The FF values for the resulting solar cells are presented in Table 5. All of the Examples showed high FF values, compared to the case where the substance which changes into a gas was not added (not shown).

### Example 6

This is an example of incorporating various organometallic compounds which change into gases by gasifying or subliming in a specific temperature range, into a conductive paste incorporated with Pb-based glass frits as the glass frits and TiO₂ as the metal oxide.

The composition (expressed in parts by weight) of the conductive paste is as presented in Table 6. The conductive paste was prepared by mixing the respective components with a planetary mixer, and dispersing the components with a triple roll mill.

**Table 6**

| | | Example 6-1 | Example 6-2 | Example 6-3 | Example 6-4 | Example 6-5 | Example 6-6 | Example 6-7 | Example 6-8 | Example 6-9 |
|---|---|---|---|---|---|---|---|---|---|---|
| Organic binder | Ethyl cellulose | 3 | 3 | 3 | 3 | 3 | 3 | 3 | 3 | 3 |
| Solvent | 2,2,4-Trimethyl-1,3-pentanediol monoisobutyrate | 13 | 13 | 13 | 13 | 13 | 13 | 13 | 13 | 13 |
| Conductive particles | Ag (spherical shape, average particle dimension 0.4 µm) | 100 | 100 | 100 | 100 | 100 | 100 | 100 | 100 | 100 |
| Glass frits | Pb-based glass frits (PbO-B₂O₃-SiO₂, amorphous shape, average particle dimension 0.1 µm) | 2 | 2 | 2 | 2 | 2 | 2 | 2 | 2 | 2 |
| Substance which changes into gas | In(C₅H₇O₂)₃ | 1 | | | | | | | | |
| | Tin octoate | | 1 | | | | | | | |
| | Y(C₅H₇O₂)₃ | | | 1 | | | | | | |
| | Nickel octoate | | | | 1 | | | | | |
| | Copper naphthenate | | | | | 1 | | | | |
| | Magnesium octoate | | | | | | 1 | | | |
| | Lead naphthenate | | | | | | | 1 | | |
| | Zinc naphthenate | | | | | | | | 1 | |
| | Ga(C₅H₇O₂)₃ | | | | | | | | | 1 |
| Metal oxide | TiO₂ (spherical shape, average particle dimension 0,2 µm) | 9 | 9 | 9 | 9 | 9 | 9 | 9 | 9 | 9 |
| FF | | 0.767 | 0.727 | 0.760 | 0.759 | 0.743 | 0.745 | 0.751 | 0.761 | 0.765 |

The firing conditions are a peak temperature of 725°C, and a firing time of 2 minutes.

The FF values for the resulting solar cells are presented in Table 6. All of the Examples showed high FF values, compared to the case where the substance which changes into a gas was not added (not shown).

### Example 7

This is an example of incorporating various organometallic compounds which change into gases by gasifying or subliming in a specific temperature range, into a conductive paste incorporated with Pb-free glass frits as the glass frits and TiO₂ as the metal oxide.

The composition (expressed in parts by weight) of the conductive paste is as presented in Table 7. The conductive paste was prepared by mixing the respective components with a planetary mixer, and dispersing the components with a triple roll mill.

**Table 7**

| | | Example 7-1 | Example 7-2 | Example 7-3 | Example 7-4 | Example 7-5 | Example 7-6 | Example 7-7 | Example 7-8 |
|---|---|---|---|---|---|---|---|---|---|
| Organic binder | Ethyl cellulose | 3 | 3 | 3 | 3 | 3 | 3 | 3 | 3 |
| Solvent | 2,2,4-Trimethyl-1,3-pentanediol monoisobutyrate | 13 | 13 | 13 | 13 | 13 | 13 | 13 | 13 |
| Conductive particles | Ag (spherical shape, average particle dimension 0.4 µm) | 100 | 100 | 100 | 100 | 100 | 100 | 100 | 100 |
| Glass frits | Pb-free glass frits (Si₂O₃-S₂O₃-SiO₂-CeO₂-LiO₂-NaO₂, amorphous shape, average particle dimension 0.1 µm) | 2 | 2 | 2 | 2 | 2 | 2 | 2 | 2 |
| Substance which changes into gas | In(C₅H₇O₂)₃ | 1 | | | | | | | |
| | Tin octoate | | 1 | | | | | | |
| | Y(C₅H₇O₂)₃ | | | 1 | | | | | |
| | Nickel octoate | | | | 1 | | | | |
| | Copper naphthenate | | | | | 1 | | | |
| | Magnesium octoate | | | | | | 1 | | |
| | Zinc naphthenate | | | | | | | 1 | |
| | Ga(C₅H₇O₂)₃ | | | | | | | | 1 |
| Metal oxide | TiO₂ (spherical shape, average particle dimension 0.2 µm) | 9 | 9 | 9 | 9 | 9 | 9 | 9 | 9 |
| FF | | 0.750 | 0.710 | 0.741 | 0.743 | 0.709 | 0.712 | 0.753 | 0.751 |

The firing conditions are a peak temperature of 725°C, and a firing time of 2 minutes.

The FF values for the resulting solar cells are presented in Table 7. All of the Examples showed high FF values, compared to the case where the substance which changes into a gas was not added (not shown).

### Example 8

This is an example of incorporating various organometallic compounds which change into gases by gasifying or subliming in a specific temperature range, into a conductive paste incorporated with Pb-based glass frits as the glass frits and SnO₂ as the metal oxide.

The composition (expressed in parts by weight) of the conductive paste is as presented in Table 8. The conductive paste was prepared by mixing the respective components with a planetary mixer, and dispersing the components with a triple roll mill.

**Table 8**

| | | Example 8-1 | Example 8-2 | Example 8-3 | Example 8-4 | Example 8-5 | Example 8-6 | Example 8-7 | Example 8-8 | Example 8-9 |
|---|---|---|---|---|---|---|---|---|---|---|
| Organic binder | Ethyl cellulose | 3 | 3 | 3 | 3 | 3 | 3 | 3 | 3 | 3 |
| Solvent | 2,2,4-Trimethyl-1,3-pentanediol monoisobutyrate | 13 | 13 | 13 | 13 | 13 | 13 | 13 | 13 | 13 |
| Conductive particles | Ag (spherical shape, average particle dimension 0.4 µm) | 100 | 100 | 100 | 100 | 100 | 100 | 100 | 100 | 100 |
| Glass frits | Pb-based glass frits (PbO-B₂O₃-SiO₂, amorphous shape, average particle dimension 0.1 µm) | 2 | 2 | 2 | 2 | 2 | 2 | 2 | 2 | 2 |
| Substance which changes into gas | In(C₅H₇O₂)₃ | 1 | | | | | | | | |
| | Tin octoate | | 1 | | | | | | | |
| | Y(C₅H₇O₂)₃ | | | 1 | | | | | | |
| | Nickel octoate | | | | 1 | | | | | |
| | Copper naphthenate | | | | | 1 | | | | |
| | Magnesium octoate | | | | | | 1 | | | |
| | Lead naphthenate | | | | | | | 1 | | |
| | Zinc naphthenate | | | | | | | | 1 | |
| | Ga(C₅H₇O₂)₃ | | | | | | | | | 1 |
| Metal oxide | SnO₂ (spherical shape, average particle dimension 0.2 µm) | 4 | 4 | 4 | 4 | 4 | 4 | 4 | 4 | 4 |
| FF | | 0.760 | 0.759 | 0.758 | 0.759 | 0.761 | 0.757 | 0.759 | 0.760 | 0.758 |

The firing conditions are a peak temperature of 725°C, and a firing time of 2 minutes.

The FF values for the resulting solar cells are presented in Table 8. All of the Examples showed high FF values.

### Example 9

This is an example of incorporating various organometallic compounds which change into gases by gasifying or subliming in a specific temperature range, into a conductive paste incorporated with Pb-free glass frits as the glass frits and SnO₂ as the metal oxide.

The composition (expressed in parts by weight) of the conductive paste is as presented in Table 9. The conductive paste was prepared by mixing the respective components with a planetary mixer, and dispersing the components with a triple roll mill.

**Table 9**

| | | Example 9-1 | Example 9-2 | Example 9-3 | Examples 9-4 | Example 9..5 | Example 9-6 | Example 9-7 | Example 9-8 |
|---|---|---|---|---|---|---|---|---|---|
| Organic binder | Ethyl cellulose | 3 | 3 | 3 | 3 | 3 | 3 | 3 | 3 |
| Solvent | 2,2,4-Trimethyl-1,3-pentanediol monoisobutyrate | 13 | 13 | 13 | 13 | 13 | 13 | 13 | 13 |
| Conductive particles | Ag (spherical shape, average particle dimension 0.4 µm) | 100 | 100 | 100 | 100 | 100 | 100 | 100 | 100 |
| Glass frits | Pb-free glass frits (Bi₂O₃-B₂O₃-SiO₂-CeO₂-LiO₂-NaO₂, amorphous shape, average particle dimension 0.1 µm) | 2 | 2 | 2 | 2 | 2 | 2 | 2 | 2 |
| Substance which changes into gas | In(C₅H₇O₂)₃ | 1 | | | | | | | |
| | Tin octoate | | 1 | | | | | | |
| | Y(C₅H₇O₂)₃ | | | 1 | | | | | |
| | Nickel octoate | | | | 1 | | | | |
| | Copper naphthenate | | | | | 1 | | | |
| | Magnesium octoate | | | | | | 1 | | |
| | Zinc naphthenate | | | | | | | 1 | |
| | Ga(C₅H₇O₂)₃ | | | | | | | | 1 |
| Metal oxide | SnO₂ (spherical shape, average particle dimension 0.2 µm) 0.2 µm) | 4 | 4 | 4 | 4 | 4 | 4 | 4 | 4 |
| FF | | 0.748 | 0.703 | 0.742 | 0.747 | 0.703 | 0.704 | 0.717 | 0.731 |

The firing conditions are a peak temperature of 725°C, and a firing time of 2 minutes.

The FF values for the resulting solar cells are presented in Table 9. All of the Examples showed high FF values, compared to the case where the substance which changes into a gas was not added (not shown).

### Example 10

This is an example of incorporating red phosphorus as the substance which changes into a gas by gasifying or subliming in a specific temperature range, into a conductive paste incorporated with Pb-based glass fruits as the glass frits and ZnO as the metal oxide.

The composition (expressed in parts by weight) of the conductive paste is as presented in Table 10. The conductive paste was prepared by mixing the respective components with a planetary mixer, and dispersing the components with a triple roll mill.

**Table 10**

| | | Example 10 |
|---|---|---|
| Organic binder | Ethyl cellulose | 3 |
| Solvent | 2,2,4-Trimethyl-1,3-pentanediol monoisobutyrate | 13 |
| Conductive particles | Ag (spherical shape, average particle dimension 0.4 µm) | 100 |
| Glass frits | Pb-based glass frits (PbO-B₂O₃-SiO₂, amorphous shape, average particle dimension 0.1 µm) | 2 |
| Substance which changes into gas | Red phosphorus | 1 |
| Metal oxide | ZnO (spherical shape, average particle dimension 0.2 µm) | 9 |
| FF | | 0.761 |

The firing conditions are a peak temperature of 780°C, and a firing time of 2 minutes.

The FF values for the resulting solar cells are presented in Table 10. The Example showed high FF values.

### Examples 11 to 13

These are examples of using the conductive paste for solar cell electrodes of the third embodiment of the present invention.

The compositions (expressed in parts by weight) of the conductive pastes are as presented in Tables 11 to 13. The conductive pastes were respectively prepared by mixing the respective components with a planetary mixer, and dispersing the components with a triple roll mill.

The firing conditions are a peak temperature of 725°C, and a firing time of in-out 2 minutes.

The respective compositions of the conductive pastes are as presented in the following Tables 11 to 13. The values of FF are presented as well. All of the Examples showed good FF values, compared to the Comparative Examples which did not include the (C) compound containing Al, Ga, In or Tl.

**Table 11**

| | | Example 11-1 | Example 11-2 | Example 11-3 | Example 11-4 | Example 11-5 | Example 11-6 | Example 11-7 | Example 11-8 | Example 11-9 | Example 11-10 | Example 11-11 | Example 11-12 | Comparative Example 11 |
|---|---|---|---|---|---|---|---|---|---|---|---|---|---|---|
| Organic binder | Ethyl cellulose | 3 | 3 | 3 | 3 | 3 | 3 | 3 | 3 | 3 | 3 | 3 | 3 | 3 |
| Solvent | 2,2,4-Trimethyl-1,3-pentanediol monoisobutyrate | 13 | 13 | 13 | 13 | 13 | 13 | 13 | 13 | 13 | 13 | 13 | 13 | 13 |
| Conductive particles | Ag (spherical shape, average particle size 0.4 µm) | 100 | 100 | 100 | 100 | 100 | 100 | 100 | 100 | 100 | 100 | 100 | 100 | 100 |
| Glass frits | Pb-based glass frits (PbO-B₂O₃-SiO₂, amorphous shape, average particle dimension 0.1 µm) | 2 | 2 | 2 | 2 | 2 | 2 | 2 | 2 | 2 | 2 | 2 | 2 | 2 |
| Compound containing Al, Ga, In or Tl (amorphous shape, average particle dimension 0.2 µm) | Al₂O₃ | 0.04 | | | | | | | | | | | | |
| | Al(OH)₃ | | 0.1 | | | | | | | | | | | |
| | Aluminum acrylate | | | 1 | | | | | | | | | | |
| | Ga₂O₃ | | | | 0.04 | | | | | | | | | |
| | Ga(OH)₃ | | | | | 0.05 | | | | | | | | |
| | Ga(C₅H₇O₂)₃ | | | | | | 1 | | | | | | | |
| | ln₂O₃ | | | | | | | 0.04 | | | | | | |
| | In(OH)₃ | | | | | | | | 0.05 | | | | | |
| | In(C₅H₇O₂)₃ | | | | | | | | | 1 | | | | |
| | Tl₂O₃ | | | | | | | | | | 0.04 | | | |
| | Tl(OH)₃ | | | | | | | | | | | 0.05 | | |
| | Tl(C₅H₇O₂)₃ | | | | | | | | | | | | 1 | |
| Specific metal oxide | ZnO (spherical shape, average particle dimension 0.2 µm) | 9 | 9 | 9 | 9 | 9 | 9 | 9 | 9 | 9 | 9 | 9 | 9 | 9 |
| FF | | 0.765 | 0.767 | 0.764 | 0.772 | 0.774 | 0.774 | 0.769 | 0.772 | 0.777 | 0.752 | 0.754 | 0.753 | 0.750 |

| | | | | | | | | | | | | | | |
|---|---|---|---|---|---|---|---|---|---|---|---|---|---|---|
| *Ga(C₅H₇O₂)₃, In(C₅H₇O₂)₃, Tl(C₅H₇O₂)₃ are all acetylacetone compounds. | | | | | | | | | | | | | | |

"

**Table 12**

| | | Example 12-1 | Example 12-2 | Example 12-3 | Example 12-4 | Example 12-5 | Example 12-6 | Example 12-7 | Example 12-8 | Example 12-9 | Example 12-10 | Example 12-11 | Example 12-12 | Comparative Example 12 |
|---|---|---|---|---|---|---|---|---|---|---|---|---|---|---|
| Organic binder | Ethyl cellulose | 3 | 3 | 3 | 3 | 3 | 3 | 3 | 3 | 3 | 3 | 3 | 3 | 3 |
| Solvent | 2,2,4-Trimethyl-1,3-pentanediol monoisobutyrate | 13 | 13 | 13 | 13 | 13 | 13 | 13 | 13 | 13 | 13 | 13 | 13 | 13 |
| Conductive particles | Ag (spherical shape, average particle size 0.4 µm) | 100 | 100 | 100 | 100 | 100 | 100 | 100 | 100 | 100 | 100 | 100 | 100 | 100 |
| Glass frits | Pb-based glass frits (PbO-B₂O₃-SiO₂, amorphous shape, average particle dimension 0.1 µm) | 2 | 2 | 2 | 2 | 2 | 2 | 2 | 2 | 2 | 2 | 2 | 2 | 2 |
| Compound containing Al, Ga, In or Tl (amorphous shape, average particle dimension 0.2 µm) | Al₂O₃ | 0.04 | | | | | | | | | | | | |
| | Al(OH)₃ | | 0.1 | | | | | | | | | | | |
| | Aluminum acrylate | | | 1 | | | | | | | | | | |
| | Ga₂O₃ | | | | 0.04 | | | | | | | | | |
| | Ga(OH)₃ | | | | | 0.05 | | | | | | | | |
| | Ga(C₅H₇O₂)₃ | | | | | | 1 | | | | | | | |
| | In₂O₃ | | | | | | | 0.04 | | | | | | |
| | In(OH)₃ | | | | | | | | 0.05 | | | | | |
| | In(C₅H₇O₂)₃ | | | | | | | | | 1 | | | | |
| | Tl₂O₃ | | | | | | | | | | 0.04 | | | |
| | Tl(OH)₃ Tl(C₅H₇O₂)₃ | | | | | | | | | | | 0.05 | | |
| | | | | | | | | | | | | | 1 | |
| Specific metal oxide | TiO₂(spherical shape, average particle dimension 0.2 µm) | 9 | 9 | 9 | 9 | 9 | 9 | 9 | 9 | 9 | 9 | 9 | 9 | 9 |
| FF | | 0.757 | 0.758 | 0.755 | 0.764 | 0.766 | 0.765 | 0.765 | 0.764 | 0.767 | 0.753 | 0.755 | 0.755 | 0.748 |

| | | | | | | | | | | | | | | |
|---|---|---|---|---|---|---|---|---|---|---|---|---|---|---|
| *Ga(C₅H₇O₂)₃, In(C₅H₇O₂)₃, Tl(C₅H₇O₂)₃ are all acetylacetone compounds. | | | | | | | | | | | | | | |

**Table 13**

| | | Exampl e13-1 | Exampl e13-2 | Exampl e 13-3 | Exampl e13-4 | Exampl e13-5 | Exampl e 13-6 | Exampl e 13-7 | Exampl e 13-8 | Exampl e 13-9 | Exampl e 13-10 | Exampl e 13-11 | Exampl e 13-12 | Compar ative Exampl |
|---|---|---|---|---|---|---|---|---|---|---|---|---|---|---|
| Organic binder | Ethyl cellulose | 3 | 3 | 3 | 3 | 3 | 3 | 3 | 3 | 3 | 3 | 3 | 3 | e 13 |
| Solvent | 2,2,4-Trimethyl-1,3-pentanediol monoisobutyrate | 13 | 13 | 13 | 13 | 13 | 13 | 13 | 13 | 13 | 13 | 13 | 13 | 13 |
| Conductive particles | Ag (spherical shape, average particle size 0.4 µm) | 100 | 100 | 100 | 100 | 100 | 100 | 100 | 100 | 100 | 100 | 100 | 100 | 100 |
| Glass frits | Pb-based glass frits (PbO-B₂O₃-SiO₂, amorphous shape, average particle dimension 0.1 µm) | 2 | 2 | 2 | 2 | 2 | 2 | 2 | 2 | 2 | 2 | 2 | 2 | 2 |
| Compound containing Al, Ga, In or Tl (amorphous shape, average particle dimension 0.2 µm) | Al₂O₃ | 0.04 | | | | | | | | | | | | |
| | Al(OH)₃ | | 0.1 | | | | | | | | | | | |
| | Aluminum acrylate | | | 1 | | | | | | | | | | |
| | Ga₂O₃ | | | | 0.04 | | | | | | | | | |
| | Ga(OH)₃ | | | | | 0.05 | | | | | | | | |
| | Ga(C₅H₇O₂)₃ | | | | | | 1 | | | | | | | |
| | In₂O₃, | | | | | | | 0.04 | | | | | | |
| | In(OH)₃ | | | | | | | | 0.05 | | | | | |
| | In(C₅H₇O₂)₃ | | | | | | | | | 1 | | | | |
| | Tl₂O₃ | | | | | | | | | | 0.04 | | | |
| | Tl(OH)₃ | | | | | | | | | | | 0.05 | | |
| | Tl(C₅H₇O₂)₃ | | | | | | | | | | | | 1 | |
| Specific metal oxide | SnO₂ (spherical shape, average particle dimension 0.2 µm) | 9 | 9 | 9 | 9 | 9 | 9 | 9 | 9 | 9 | 9 | 9 | 9 | 9 |
| FF | | 0.755 | 0.756 | 0.755 | 0.758 | 0.756 | 0.758 | 0.757 | 0.759 | 0.760 | 0.751 | 0.751 | 0.752 | 0.742 |

| | | | | | | | | | | | | | | |
|---|---|---|---|---|---|---|---|---|---|---|---|---|---|---|
| *Ga(C₅H₇O₂)₃, In(C₅H₇O₂)₃, Tl(C₅H₇O₂)₃ are all acetylacetone compounds. | | | | | | | | | | | | | | |

## Claims

1. A conductive paste for solar cell electrodes, comprising an organic binder, a solvent, conductive particles, glass fruits, and (A) a substance which changes into a gas at a temperature in the range of 150 to 800°C, and a metal oxide, (B) an organometallic compound and a metal oxide, or (C) a compound containing Al, Ga, In or Tl.

2. The conductive paste for solar cell electrodes according to claim 1, comprising an organic binder, a solvent, conductive particles, glass frits, and (A) a substance which changes into a gas at a temperature in the range of 150 to 800°C, and a metal oxide.

3. The conductive paste for solar cell electrodes according to claim 2, wherein the metal oxide is one or more selected from the group consisting of zinc oxide, titanium oxide and tin oxide.

4. The conductive paste for solar cell electrodes according to claim 2 or 3, wherein the substance which changes into a gas is an organometallic compound.

5. The conductive paste for solar cell electrodes according to claim 4, wherein the organometallic compound is one or more selected from the group consisting of acetylacetone metal complexes, metal acetoacetate complexes, diethylmalonic acid ester metal complexes, cyclopentadiene complexes, metal naphthenate compounds, metal octoate compounds, metal stearate compounds and metal palmitate compounds.

6. The conductive paste for solar cell electrodes according to any one of claims 1 to 5, wherein the content of the glass frits is 0.5 to 10 parts by weight, the content of the substance which changes into a gas is 0.1 to 10 parts by weight, and the content of the metal oxide is 0.5 to 15 parts by weight, all relative to 100 parts by weight of the conductive particles.

7. The conductive paste for solar cell electrodes according to claim 1, comprising an organic binder, a solvent, conductive particles, glass frits, and (B) an organometallic compound and a metal oxide.

8. The conductive paste for solar cell electrodes according to claim 7, wherein the organometallic compound is one or more selected from the group consisting of acetylacetone metal complexes, metal acetoacetate complexes, diethylmalonic acid ester metal complexes, cyclopentadiene complexes, metal naphthenate compounds, metal octoate compounds, metal stearate compounds and metal palmitate compound.

9. The conductive paste for solar cell electrodes according to claim 7 or 8, wherein the metal oxide is one or more selected from the group consisting of zinc oxide, titanium oxide and tin oxide.

10. The conductive paste for solar cell electrodes according to any one of claims 7 to 9, wherein the content of the glass frits is 0.5 to 10 parts by weight, the content of the organometallic compound is 0.1 to 10 parts by weight, and the content of the metal oxide is 0.5 to 15 parts by weight, all relative to 100 parts by weight of the conductive particles.

11. The conductive paste for solar cell electrodes according to claim 1, comprising an organic binder, a solvent, conductive particles, glass frits, and (C) a compound containing Al, Ga, In or Tl.

12. The conductive paste according to claim 11, used to form an electrode on the N-type semiconductor.

13. The conductive paste according to claim 11 or 12, wherein the compound is an oxide, a hydroxide or an organometallic compound.

14. The conductive paste according to claim 13, wherein the organometallic compound is an acetylacetone metal complex, a metal acetoacetate complex, a diethylmalonic acid ester metal complex, a cyclopentadiene complex, a metal naphthenate compound, a metal octoate compound, a metal stearate compound and a metal palmitate compound.

15. The conductive paste according to any one of claims 11 to 14, further comprising zinc oxide, titanium oxide, tin oxide, copper oxide or nickel oxide.

16. An electrode for solar cells, formed by firing the conductive paste for solar cell electrodes according to any one of claims 1 to 15.

17. A solar cell equipped with the electrode according to claim 16.

18. A method for producing a solar cell, the method comprising forming an electrode by firing the conductive paste for solar cell electrodes according to any one of claims 1 to 15.
